# EUROPÄISCHE PATENTSCHRIFT

(11) **EP 0 899 783 B1**
(45) Veröffentlichungstag und Bekanntmachung des Hinweises auf die Patenterteilung: **16.04.2008**
(21) Anmeldenummer: 98115375.2
(22) Anmeldetag: 14.08.1998
(51) Int. Cl.: H01L 21/8238, H01L 27/092

(54) **Schaltungsanordnung mit mindestens vier Transistoren und Verfahren zu dessen Herstellung**
Circuit arrangement with at least four transistors and method of fabrication
Arrangement de circuit comportant au moins quatre transistors et procédé de fabrication

(30) Priorität: 22.08.1997 DE 19736672
(43) Veröffentlichungstag der Anmeldung: 03.03.1999
(73) Patentinhaber: Qimonda AG, 81739 München (DE)
(72) Erfinder: Risch, Lothar, Dr., 85579 Neubiberg (DE); Roesner, Wolfgang, Dr., 81739 München (DE); Aeugle, Thomas, Dr., 81735 München (DE); Schulz, Thomas, 81739 München (DE)
(74) Vertreter: Epping - Hermann - Fischer

(56) Entgegenhaltungen:
- EP-A- 0 657 930
- EP-A- 0 721 221
- DE-A- 3 838 355
- US-A- 5 032 529
- US-A- 5 612 563
- US-A- 5 627 395

## Beschreibung

Die Erfindung betrifft eine Schaltungsanordnung mit mindestens vier Transistoren. Zwei der vier Transistoren sind zu den übrigen zwei Transistoren komplementär. Die vier Transistoren sind insbesondere als NAND-Gatter geeignet.

Bei der Entwicklung neuer integrierter Schaltungsanordnungen wird eine erhöhte Packungsdichte angestrebt. Die Realisierung erfolgt derzeit meist in einer planaren Siliziumtechnologie.

NAND-Gatter sind häufig verwendete logische Elemente von Schaltungsanordnungen. Liefert mindestens eine von zwei Eingangsspannungsanschlüssen eines NAND-Gatters ein Signal in Form einer Spannung, erhält man am Ausgangsspannungsanschluß des NAND-Gatters ebenfalls ein Signal. In K. Hoffmann, VLSI-Entwurf, Modelle und Schaltungen, Oldenburg 1990, Seite 365 ist ein typisches Layout eines NAND-Gatters dargestellt.

Geringere Strukturgrößen in planarer Technologie können erzielt werden, wenn die optische Lithographie durch Elektronenstrahllithographie, deren Auflösungsvermögen wesentlich besser ist, ersetzt wird, siehe z.B. T. Mizuno, R. Ohaba, IEDM Techn. Dig. Seite 109, 1996). Da die Elektronenstrahllithographie jedoch langsam ist, erscheint sie für einen Einsatz in einer Halbleiterfertigung aus wirtschaftlichen Gründen ungeeignet.

Zur Verkleinerung der Fläche eines MOS-Transistors werden vertikale Transistoren untersucht. Da die Kanallänge bezüglich einer Oberfläche eines Substrats vertikal verläuft, kann die Fläche eines vertikalen Transistors kleiner sein als die herkömmlicher planarer Transistoren. Eine weitere Verkleinerung der Fläche erzielt man durch Verkleinerung der für eine bestimmte Stromstärke nötige Kanalweite, indem die Kanallänge verkürzt wird. In L. Risch, W. H. Krautschneider, F. Hofmann, Vertical MOS-Transistor with 70 nm Channel Length, ESSDERC 1995, Seite 101 bis 104 werden vertikale MOS-Transistoren beschieben. Zur ihrer Herstellung werden von alternierenden Leitfähigkeitstypen dotierte Schichten in Form einer Schichtenfolge entsprechend Source, Kanal und Drain gebildet, die ringförmig von Gatedielektrikum und Gateelektrode umgeben werden.

In der deutschen Patentschrift DE 43 41 667 C1 wird ein NAND-Gatter beschrieben, bei dem zwei parallel verschaltete vertikale MOS-Transistoren in einer gemeinsamen Schichtenfolge realisiert sind, und Schichtenfolgen zweier in Reihe geschalteter vertikaler MOS-Transistoren übereinander angeordnet sind.

In der deutschen Patentschrift DE 38 38 355 A1 wird eine Vertikaltransistoranordnung beschrieben, die aus einer vertikalen Schichtenfolge aus Hlableitermaterial unterschiedlichen Leitungstyps aufgebaut ist.

In der Patentschrift US 5,032,529 ist ein VMOS-Transistor gezeigt, der Gatebereiche als dielektrische Grabenstrukturen aufweist, wobei benachbarte Transistoren bestimmte Gatebereiche gemeinsam nutzen können.

Der Erfindung liegt das Problem zugrunde, eine Schaltungsanordnung mit mindestens vier Transistoren, die mit verbesserten Schaltungseigenschaften herstellbar ist, anzugeben. Ferner soll ein Verfahren zur Herstellung einer solchen Schaltungsanordnung angegeben werden.

Dieses Problem wird gelöst durch eine Schaltungsanordnung gemäß Anspruch 1 sowie durch ein Verfahren zu dessen Herstellung gemäß Anspruch 4. Ausgestaltungen der Erfindung gehen aus den übrigen Ansprüchen hervor.

In einer erfindungsgemäßen Schaltungsanordnung sind die vier Transistoren vertikale MOS-Transistoren. Ein erster der Transistoren und ein vierter der Transistoren sind komplementär zu einem zweiten der Transistoren und einem dritten Transistoren. Der erste Transistor und der vierte Transistor sind in Reihe und zwischen einem ersten Spannungsanschluß und einem Ausgangsspannungsanschluß geschaltet. Der zweite Transistor und der dritte Transistor sind parallel verschaltet und zwischen dem Ausgangsspannungsanschluß und einem zweiten Spannungsanschluß geschaltet. Eine Gateelektrode des dritten Transistors und eine Gateelektrode des vierten Transistors sind mit einem ersten Eingangsspannungsanschluß verbunden. Eine Gateelektrode des ersten Transistors und eine Gateelektrode des zweiten Transistors sind mit einem zweiten Eingangsspannungsanschluß verbunden. Es sind Schichtstrukturen vorgesehen, die Kanalschichten der Transistoren und mindestens ein Source/Drain-Gebiet jedes Transistors umfassen. Die Schichtstrukturen weisen Flanken auf, an die die Kanalschichten angrenzen und die mindestens im Bereich der Kanalschichten mit einem Gatedielektrikum versehen sind, an das die Gateelektroden der Transistoren angrenzen. Die Kanalschicht des ersten Transistors und die Kanalschicht des vierten Transistors befinden sich in gleicher Höhe. Die Kanalschicht des zweiten Transistors und die Kanalschicht des dritten Transistors befinden sich in gleicher Höhe. Die Kanalschicht des ersten Transistors und die Kanalschicht des zweiten Transistors befinden sich in unterschiedlicher Höhe.

Die Schaltungsanordnung läßt sich aus einer einzigen Schichtenfolge mit nur vier Schichten erzeugen. In diesem Fall grenzen eine der Schichten, die die Kanalschichten des ersten und des vierten Transistors umfaßt, und eine der Schichten, die die Kanalschichten des zweiten und des dritten Transistors umfaßt, aneinander an. Eine kleine Anzahl an Schichten bietet den Vorteil, daß Dotierungsprofile der Schichten weniger zerlaufen.

Es ist vorteilhaft, wenn die Schichtstrukturen beidseitig, d.h. mindestens an zwei gegenüberliegenden Flanken der Schichtstruktur, mit dem Gatedielektrikum und den Gateelektrode versehen werden. Im Gegensatz zu einer einseitigen Anordnung wird bei der beidseitigen Anordnung, ohne daß sich die Fläche der vertikalen MOS-Transistoren deswegen vergrößert, deren Kanalweite verdoppelt und damit der Strom erhöht und die Ausbildung von Raumladungszonen zwischen den zwei Flanken in der Kanalschicht vergrößert. Dies ist vorteilhaft, da in Raumladungszonen keine Leckströme aufgrund eines parasitären Bipolartransistors entstehen. Aus diesem Grund ist es auch vorteilhaft, wenn sich innerhalb der gesamten Kanalschicht eine Raumladungszone ausbildet.

Es ist vorteilhaft, zur Erhöhung der Packungsdichte die für eine bestimmte Stromstärke nötige Kanalweite eines Transistors zu verkleinern, indem die Kanallänge des Transistors verkürzt wird. Für den vertikalen MOS-Transistor läßt sich eine kurze Kanallänge leicht realisieren, da die Kanallänge durch die Dicke der Kanalschicht bestimmt wird und damit nicht durch die minimale, in der jeweilgen Technologie herstellbare Strukturgröße begrenzt ist. Um bei kurzer Kanallänge Leckströme aufgrund von Punch-Through zu vermeiden, sollte die Kanalschicht hoch dotiert werden.

Da Raumladungszonen umso kleiner werden, je höher die Dotierstoffkonzentration der Kanalschicht ist, muß, um bei kurzer Kanallänge innerhalb der gesamten Kanalschicht eine Raumladungszone zu erhalten, eine Abmessung zwischen zwei gegenüberliegenden Flanken der Schichtstruktur besonders klein werden. Dazu wird die Schichtstruktur mit Hilfe eines als Maske dienenden Spacers erzeugt. Die Abmessung zwischen den zwei gegenüberliegenden Flanken der Schichtstruktur wird so klein, daß bei entsprechender Ansteuerung der Gateelektrode der vertikale MOS-Transistor vollständig verarmt. Bei einer üblichen Spannung von 0V-2V beträgt damit die Abmessung ca. 30nm-90nm.

Die Schichtenfolge kann auf einer Oberfläche eines Substrats ganzflächig durch epitaktisches Aufwachsen von in situ dotiertem Halbleitermaterial erzeugt werden. Es kann auch eine Vertiefung im Substrat erzeugt werden, in der die Schichtenfolge durch epitaktisches Aufwachsen erzeugt wird. Es kann auch ein Material auf die Oberfläche abgeschieden werden, in dem eine Vertiefung erzeugt wird, die bis zur Oberfläche reicht und in der die Schichtenfolge durch epitaktisches Aufwachsen erzeugt wird. Beim epitaktischen Aufwachsen der Schichtenfolge in der Vertiefung bilden sich an Rändern der Vertiefung Facetten, da an diesen Rändern die Aufwachsrate bei der selektiven Epitaxie geringer ist. Die Schichten werden dadurch besonders dünn, was zu einer besonders kleinen Kanallänge führt. Schichten der Schichtenfolge können auch durch Implantation mit jeweils unterschiedlich geladenen Ionen und unterschiedlicher Reichweite erzeugt werden. Für diese Schichten ist epitaktisches Aufwachsen nicht notwendig und für die Schichtstruktur wird das Substrat strukturiert. Die Schichtenfolge kann eine Siliziumschicht und/oder eine Si₍₁₋ₓ₎Geₓ-Schicht enthalten.

Da der erste Transistor und der vierte Transistor nicht zueinander komplementär sind, können der erste Transistor und der vierte Transistor in denselben Verfahrensschritten hergestellt werden, was eine Prozeßvereinfachung bedeutet. Dasselbe gilt analog auch für den zweiten Transistor und den dritten Transistor.

Zur Erzeugung der Schichtenfolge werden mindestens vier von z.B. alternierenden Leitfähigkeitstypen dotierte Schichten erzeugt. Besteht die Schichtenfolge aus mehr als vier Schichten, müssen die Leitfähigkeitstypen benachbarter Schichten nicht entgegengesetzt sein. Zueinander komplementäre Transistoren werden bezüglich einer Achse, die senkrecht zu der Oberfläche des Substrats verläuft, in unterschiedlicher Höhe gebildet. Das bedeutet, daß aus mindestens zwei der vier Schichten sowohl Kanalschichten als auch Source/Drain-Gebiete entstehen.

Es können auch mehr als vier Schichten gebildet werden.

Wird die Schichtstruktur mit Hilfe eines Spacers als Maske erzeugt, so wird eine Kante gebildet, entlang der durch Abscheiden und Rückätzen von Material der Spacer entsteht. Die Kante kann durch Abscheiden und Strukturieren einer ersten Hilfsschicht oberhalb der Schichtenfolge erzeugt werden. Die Kante kann auch durch maskiertes Ätzen der Schichtenfolge entstehen.

Schichtstrukturen von zueinander komplementären vertikalen MOS-Transistoren werden gebildet, indem eine erste Maske auf die Schichtenfolge aufgebracht, und anschließend mindestens zwei Schichtdicken tief geätzt wird. Dadurch entsteht eine Schichtstruktur und eine vorläufige Schichtstruktur. Dann wird die erste Maske entfernt. Die Schichtstruktur wird anschließend mit einer zweiten Maske abgedeckt. Dann wird eine Schichtdicke tief geätzt, wodurch eine Schichtstruktur entsteht, die um eine Schichtdicke tiefer liegt als die abgedeckte Schichtstruktur.

Alternativ kann zuerst ein Bereich, in dem eine der Schichtstrukturen erzeugt werden soll, durch die zweite Maske abgedeckt werden und anschließend eine Schichtdicke tief Silizium geätzt werden. Die zweite Maske wird entfernt. Anschließend wird die erste Maske zur Erzeugung der Schichtstrukturen aufgebracht. Mit der ersten Maske wird anschließend mindestens zwei Schichtdicken tief geätzt, wodurch im vorher abgedeckten Bereich eine Schichtstruktur entsteht, die um eine Schichtdicke höher liegt als eine Schichtstruktur, die im nicht abgedeckten Bereich entsteht.

Alternativ kann zuerst eine erste erste Maske zur Bildung einer ersten der Schichtstrukturen erzeugt werden. Die erste erste Maske wird durch eine zweite Maske abgedeckt. Anschließend wird eine Schichtdicke tief geätzt. In einem von der zweiten Maske nicht abgedeckten Bereich wird anschließend eine zweite erste Maske für eine zweite der Schichtstrukturen gebildet. Die zweite Maske wird aus einem anderen Material als die ersten Masken gebildet und nach Erzeugung der zweiten Maske entfernt. Anschließend wird mindestens zwei Schichtdikken tief geätzt, wodurch die Schichtstrukturen entstehen.

Für diese Methoden sind im wesentlichen gleiche Schichtdicken der Schichten zweckmäßig.

Die erste Maske besteht z.B. aus vier voneinander getrennten Teilen. Zur Erhöhung der Packungsdichte sowie zur Prozeßvereinfachung können elektrische Verbindungen realisiert werden, indem die vier Schichtstrukturen teilweise oder ganz zusammenhängen. Hängen Schichtstrukturen ganz zusammen, so ist die erste Maske weniger als vierteilig. Ist das Zusammenhängen von Schichtstrukturen nicht erwünscht, so können, bei weniger als vierteiliger erster Maske, die Schichtstrukturen zu einem späteren Zeitpunkt voneinander getrennt werden.

Es ist vorteilhaft, wenn ein erstes Source/Drain-Gebiet des zweiten Transistors und ein erstes Source/Drain-Gebiet des dritten Transistors, die mit dem zweiten Spannungsanschluß verbunden sind, oberhalb der zugehörigen Kanalschichten angeordnet sind. Dadurch kann die Schicht, aus der ein zweites Source/Drain-Gebiet des zweiten Transistors und ein zweites Source/Drain-Gebiet des dritten Transistors entstehen, als elektrische Verbindung zwischen diesen Source/Drain-Gebieten dienen. Zur Verbindung der ersten Source/Drain-Gebiete des zweiten Transistors und des dritten Transistors wird eine leitende Struktur erzeugt. Statt dessen kann das erste Source/Drain-Gebiet des zweiten Transistors und das erste Source/Drain-Gebiet des dritten Transistors unterhalb der zugehörigen Kanalschichten angeordnet sind.

Es ist vorteilhaft, das zweite Source/Drain-Gebiet des dritten Transistors und ein zweites Source/Drain-Gebiet des vierten Transistors, die mit dem Ausgangsspannungsanschluß verbunden sind, über die Transistoren hinaus zu verlängern und eine Stufe zu bilden. Dazu grenzt die Schicht, aus der das zweite Source/Drain-Gebiet des vierten Transistors entsteht, an die Schicht, aus der das zweite Source/Drain-Gebiet des dritten Transistors entsteht, an. An dieser Stufe wird ein Kontakt des Ausgangsspannungsanschlusses angeordnet. Der Prozeßaufwand verringert sich, da für die Verbindung der zweiten Source/Drain-Gebiete des zweiten Transistors, des dritten Transistors und des vierten Transistors keine zusätzliche Leitungen benötigt werden. Um in diesem Fall ein erstes Source/Drain-Gebiet des vierten Transistors mit dem zweiten Source/Drain-Gebiet des ersten Transistors über eine leitende Struktur mit gleich tiefen Kontakten zu verbinden, wird das zweite Source/Drain-Gebiet des ersten Transistors oberhalb der Kanalschicht des ersten Transistors gebildet. Ein Kontakt des ersten Spannungsanschlusses wird auf der Schicht gebildet, aus der das erste Source/Drain-Gebiet des ersten Transistors entsteht.

Werden die zweiten Source/Drain-Gebiete des zweiten Transistors, des dritten Transistors und des vierten Transistors anders miteinander verbunden, wie z.B. über eine leitende Struktur, kann das erste Source/Drain-Gebiet des vierten Transistors unterhalb der Kanalschicht des vierten Transistors und das zweite Source/Drain-Gebiet des ersten Transistors unterhalb der Kanalschicht des ersten Transistors angeordnet werden. Die Verbindung zwischen dem ersten Source/Drain-Gebiet des vierten Transistors und dem zweiten Source/Drain-Gebiet des ersten Transistors geschieht dann über die Schicht, aus der sie entstanden sind.

Um leitende Strukturen in nur einer Ebene parallel zur Oberfläche zu realisieren, ist es vorteilhaft, die vier Transistoren so anzuordnen, daß eine Verbindungslinie, die den ersten Transistor mit dem zweiten Transistor, den zweiten Transistor mit dem dritten Transistor, den dritten Transistor mit dem vierten Transistor und den vierten Transistor mit dem ersten Transistor verbindet, im wesentlichen viereckig ist. In diesem Fall kann der Kontakt des ersten Eingangsspannungsanschlusses zwischen dem dritten Transistor und dem vierten Transistor und ein Kontakt des zweiten Eingangsspannungsanschlusses zwischen dem ersten Transistor und dem zweiten Transistor angeordnet werden. Andere Anordnungen, wie z.B. entlang einer Linie, sind ebenfalls denkbar.

Es ist vorteilhaft, die Gateelektroden als Spacer auszubilden, weil so die Gateelektroden klein werden und selbstjustiert erzeugt werden können. Dazu wird leitendes Material abgeschieden und anschließend geätzt, bis die Gateelektroden als Spacer entstehen. Um Kontaktflächen für den Kontakt des ersten Eingangsspannungsanschlusses und für den Kontakt des zweiten Eingangsspannungsanschlusses zu erzeugen, ist es vorteilhaft, die Schichtstruktur des ersten Transistors und die Schichtstruktur des zweiten Transistors bzw. die Schichtstruktur des dritten Transistors und die Schichtstruktur des vierten Transistors in geringem Abstand voneinander zu erzeugen. Beim Ätzen des leitenden Materials wird eine Maske verwendet, die die erste Schichtstruktur und die zweite Schichtstruktur bzw. die dritte Schichtstruktur und die vierte Schichtstruktur etwas überlappt. Das leitende Material unter dieser Maske bildet die Kontaktflächen. Außerdem verbindet es die Gateelektroden des dritten Transistors und des vierten Transistors bzw. die Gateelektroden des ersten Transistors und des zweiten Transistors miteinander.

Die vier Transistoren der Schaltungsanordnung sind insbesondere als NAND-Gatter geeignet. Da weitere Anschlüsse an andere Elemente der Schaltungsanordnung möglich sind, muß es sich bei den vier Transistoren nicht unbedingt um ein NAND-Gatter handeln.

Im folgenden wird ein Ausführungsbeispiel der Erfindung, das in den Figuren dargestellt ist, näher erläutert.
- Figur 1: zeigt ein erstes Substrat, nachdem durch Implantation mit Hilfe einer Maske eine erste dotierte Schicht erzeugt wurde und eine zweite Schicht, eine dritte Schicht und eine vierte Schicht epitaktisch aufgewachsen wurden, eine erste Hilfsschicht aufgetragen und strukturiert, sowie an ersten Kanten und an zweiten Kanten der Hilfsschicht erste Spacer und zweite Spacer erzeugt wurden.
- Figur 2: zeigt einen zum Querschnitt aus Figur 1 parallelen Querschnitt durch das Substrat, nachdem die erste Hilfsschicht entfernt wurde, und eine erste Schichtstruktur, eine zweite Schichtstruktur (in dieser Figur nicht dargestellt), eine dritte Schichtstruktur (in dieser Figur nicht dargestellt) und eine vierte Schichtstruktur erzeugt wurden.
- Figur 3: zeigt den Querschnitt aus Figur 1 nach den Prozeßschritten aus Figur 2.
- Figur 4: zeigt einen zum Querschnitt aus Figur 2 und Figur 3 parallelen Querschnitt durch das Substrat, nachdem eine erste isolierende Struktur und eine zweite isolierende Struktur erzeugt wurden.
- Figur 5: zeigt den Querschnitt aus Figur 2 nach den Prozeßschritten aus Figur 4.

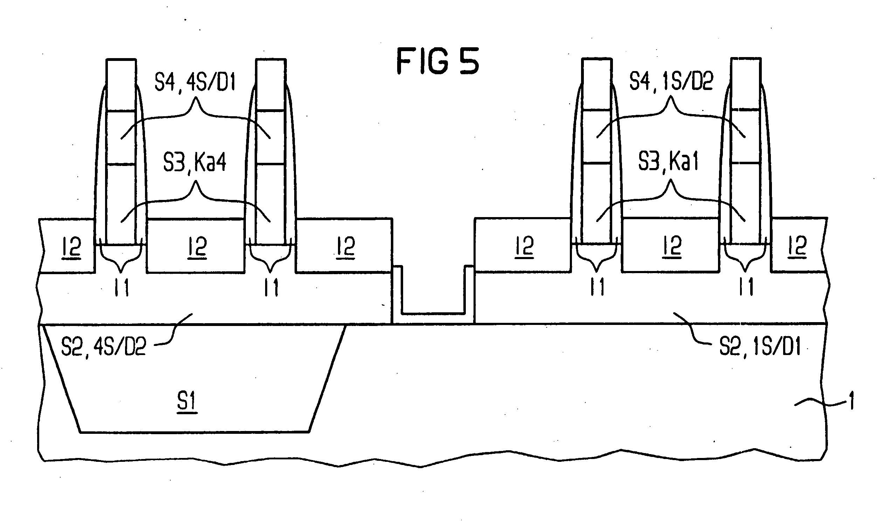

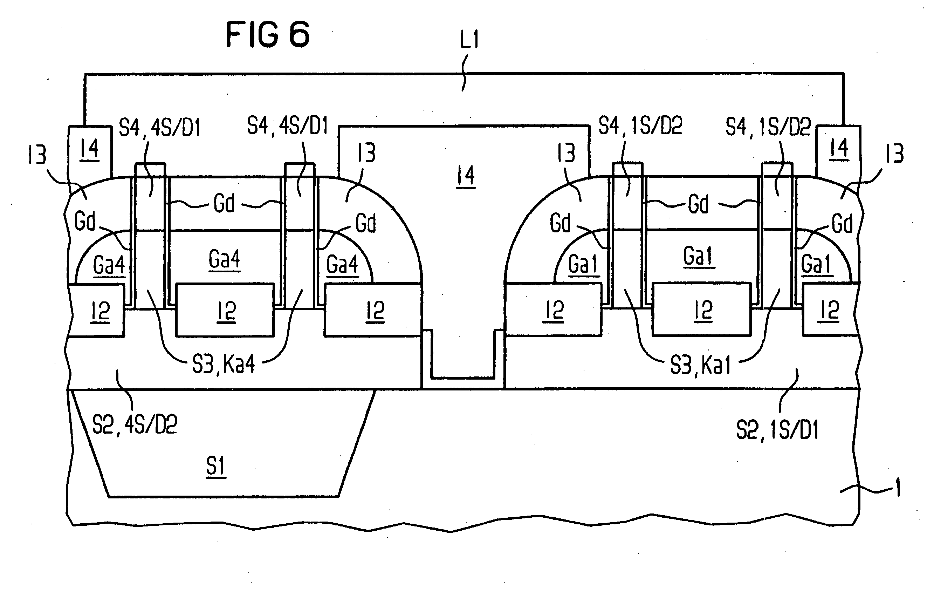

- Figur 6: zeigt den Querschnitt aus Figur 5, nachdem die erste isolierende Struktur teilweise entfernt wurde, ein Gatedielektrikum, eine erste Gateelektrode, eine zweite Gateelektrode (nicht dargestellt), eine dritte Gateelektrode (nicht dargestellt), eine vierte Gateelektrode, eine dritte isolierende Struktur, eine vierte isolierende Struktur, ein erster Kontakt, ein zweiter Kontakt, ein dritter Kontakt, ein vierter Kontakt, ein fünfter Kontakt, ein sechster Kontakt, ein siebter Kontakt, ein achter Kontakt eine erste leitende Struktur und eine zweite leitende Struktur (nicht dargestellt) erzeugt wurden. Die Kontakte sind in dieser Figur nicht alle dargestellt.
- Figur 7: zeigt den Querschnitt aus Figur 4 nach den Prozeßschritten aus Figur 6.
- Figur 8: zeigt einen Ausschnitt aus einer Aufsicht auf das Substrat, in dem die erste Schichtstruktur, die zweite Schichtstruktur, die dritte Schichtstruktur, die vierte Schichtstruktur, der erste Bereich, der zweite Bereich, der dritte Bereich, der vierte Bereich, die erste Schicht, der erste Kontakt, der zweite Kontakt, der dritte Kontakt, der vierte Kontakt, der fünfte Kontakt, der sechste Kontakt, der siebte Kontakt, der achte Kontakt, die x-Achse und die y-Achse dargestellt sind.
- Figur 9: zeigt eine Aufsicht auf das Substrat, in dem die Schichtstrukturen, die Kontakte, und die zweite Maske dargestellt sind.
- Figur 10: zeigt einen Ausschnitt aus einer Aufsicht auf das Substrat, in dem die Schichtstrukturen, die Kontakte, die fünften Bereiche und die vierte Fotolackmaske dargestellt sind.
- Figur 11: zeigt einen Ausschnitt aus einer Aufsicht auf das Substrat, in dem die Schichtstrukturen, die Kontakte, die erste leitende Struktur und die zweite leitende Struktur dargestellt sind.
- Figur 12: zeigt ein Schaltbild eines NAND-Gatters.

Die Figuren sind nicht maßstäblich.

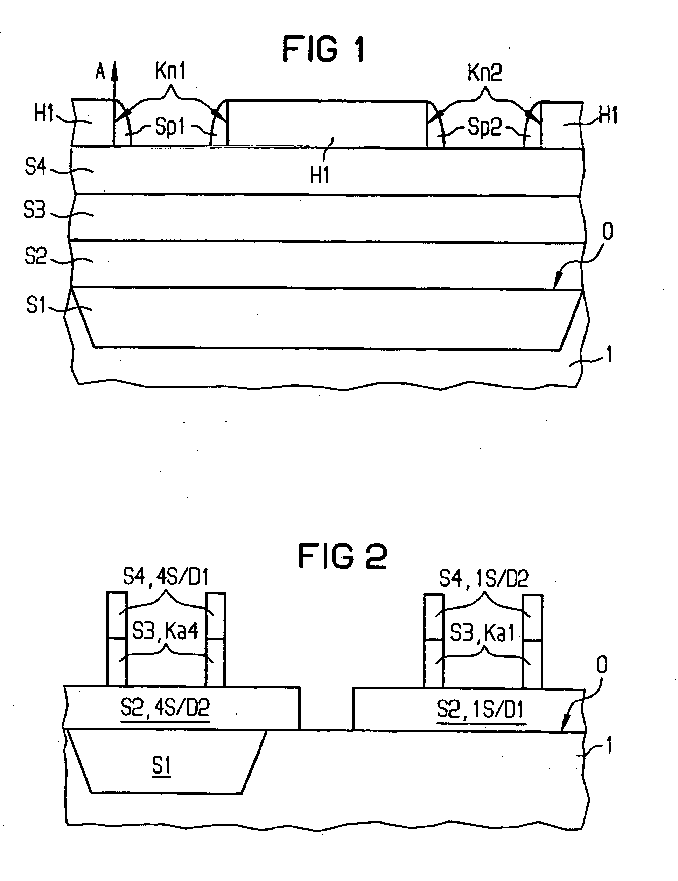

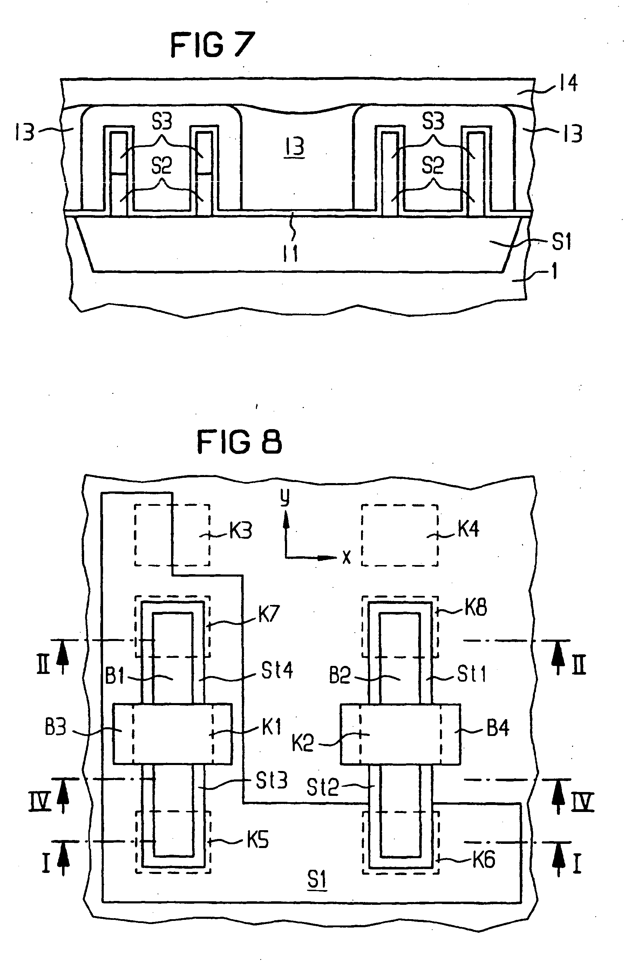

In einem ersten Ausführungsbeispiel wird mit Hilfe einer ersten Fotolackmaske (nicht dargestellt), die einen l-förmigen Bereich mit zusätzlichem Ausläufer nicht bedeckt, durch Implantation eine ca.300nm dicke p-dotierte erste Schicht S1 in einem Substrat 1 aus Silizium erzeugt. Die Dotierstoffkonzentration der ersten Schicht beträgt ca. 10²¹ cm⁻³. Anschließend wird an einer Oberfläche O des Substrats 1 durch epitaktisches Aufwachsen eine n-dotierte zweite Schicht S2, eine p-dotierte dritte Schicht S3 und eine n-dotierte vierte Schicht S4 erzeugt. Die Dotierstoffkonzentrationen der zweiten Schicht S2, der dritten Schicht S3 und der vierten Schicht S4 betragen jeweils ca. 10¹⁸ cm⁻³. Die zweite Schicht S2, die dritte Schicht S3 und die vierte Schicht S4 sind jeweils ca. 200 nm dick. Anschließend wird die Dotierstoffkonzentration der vierten Schicht S4 durch Implantation auf 10²¹cm⁻³ erhöht. Durch Abscheiden von SiO₂ in einer Dicke von ca. 200 nm wird eine erste Hilfsschicht H1 erzeugt. Mit Hilfe einer zweiten Fotolackmaske (nicht dargestellt), die einen ersten länglichen rechteckigen Bereich B1 und einen dazu parallel verlaufenden länglichen rechteckigen zweiten Bereich B2 nicht bedeckt, wird SiO₂ geätzt, bis die vierte Schicht S4 teilweise freigelegt wird. Dadurch entstehen an Rändern des ersten Bereichs B1 eine erste Kante Kn1 und an Rändern des zweiten Bereichs B2 zweite Kanten Kn2. Der erste Bereich B1 und der zweite Bereich B2 sind jeweils bezüglich einer zur Oberfläche O parallel verlaufenden x-Achse x ca. 400 nm breit und bezüglich einer zur Oberfläche O parallel verlaufenden und zur x-Achse x senkrechten y-Achse y 2400 nm lang. Eine Verbindungslinie zwischen einem Mittelpunkt des ersten Bereichs B1 und einem Mittelpunkt des zweiten Bereichs B2 verläuft parallel zur x-Achse (s. Fig. 8). Durch Abscheiden und Rückätzen von Siliziumnitrid werden an der ersten Kante Kn1 erste Spacer Sp1 und an der zweiten Kante Kn2 zweite Spacer Sp2 erzeugt (siehe Figur 1).

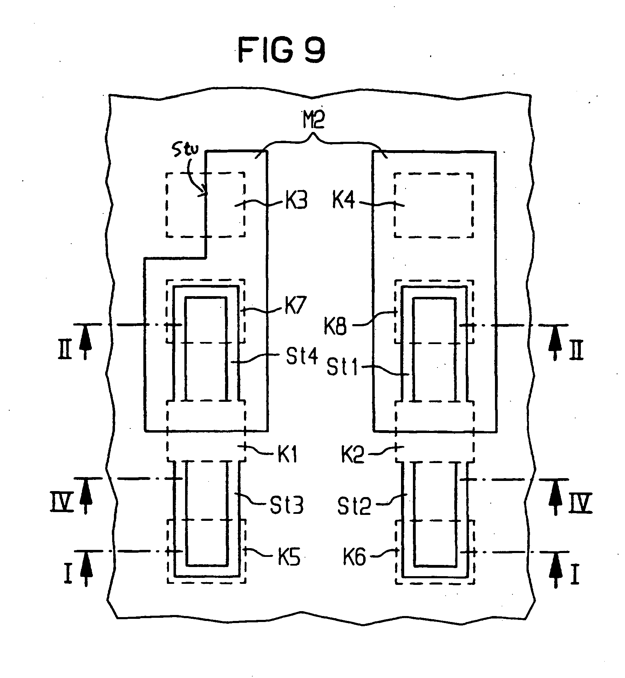

Anschließend wird durch Ätzen mit z.B. NH₄F/HF die strukturierte erste Hilfsschicht H1 entfernt. Um vier voneinander getrennte Schichtstrukturen zu erhalten, werden der erste Spacer Sp1 und der zweite Spacer Sp2 mit Hilfe einer dritten Fotolackmaske (nicht dargestellt), die einen den ersten Bereich B1 quer überlappenden rechteckigen dritten Bereich B3 und einen den zweiten Bereich B2 quer überlappenden rechtekkigen vierten Bereich B4 nicht bedeckt, teilweise entfernt. Der strukturierte erste Spacer Sp1 und der strukturierte zweite Spacer Sp2 bilden zusammen eine erste Maske. Durch Ätzen von Silizium selektiv zu Siliziumnitrid mit z.B. HBr/NF₃/He/O₂ werden anschließend Teile der vierten Schicht S4 und der dritten Schicht S3 entfernt. Dadurch entstehen eine erste Schichtstruktur St1, eine vorläufige zweite Schichtstruktur, eine vorläufige dritte Schichtstruktur und eine vierte Schichtstruktur St4. Anschließend wird eine zweite Maske M2, die eine Hälfte des ersten Bereichs B1 und eine Hälfte des zweiten Bereichs B2 überlappt, erzeugt, indem SiO₂ abgeschieden und durch ein fotolithographisches Verfahren strukturiert wird. Mit z.B. Cl₂/CHF₃ als Ätzmittel wird Silizium selektiv zu SiO₂ geätzt, bis die zweite Schicht S2 an ungeschützten Stellen entfernt wird. Dadurch entstehen aus der vorläufigen zweiten Schichtstruktur und aus der vorläufigen dritten Schichtstruktur eine zweite Schichtstruktur St2 und eine dritte Schichtstruktur St3 (siehe Figur 2, Figur 3 und Figur 9). Die zweite Maske M2 ist über den ersten Bereich B1 hinaus teilweise lateral an die erste Schicht S1 angrenzend ausgedehnt, weswegen aus der ersten Schicht S1 und aus der zweiten Schicht S2 eine Stufe Stu gebildet wird (siehe Figur 9). Die zweite Maske M2 ist über den zweiten Bereich B2 hinaus ausgedehnt. Die durch die zweite Maske M2 außerhalb des ersten Bereichs B1 und des zweiten Bereichs B2 befindlichen geschützten Teile der zweiten Schicht S2 dienen als elektrische Verbindungen.

Durch Implantation wird die Dotierstoffkonzentration der dritten Schicht S3 in der zweiten Schichtstruktur St2 und der dritten Schichtstruktur St3 auf ca. 10²¹cm⁻³ erhöht. Dazu wird die zweite Maske M2 beibehalten. Durch Ätzen mit z.B. HF wird die zweite Maske M2 anschließend entfernt.

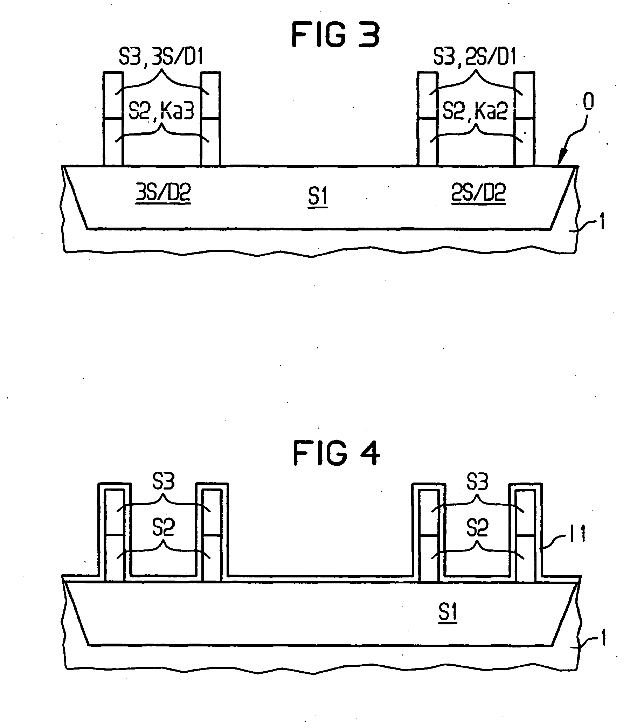

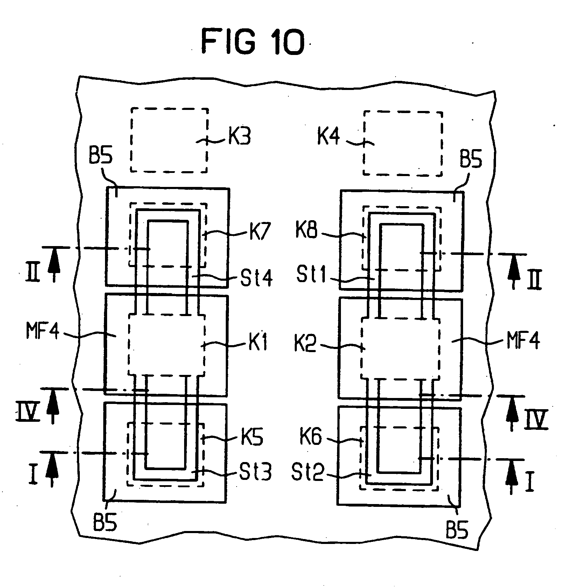

Anschließend wird Siliziumnitrid in einer Dicke von ca. 80nm abgeschieden (siehe Figur 4). Durch Abscheiden und Strukturieren von SiO₂ wird eine dritte Maske (nicht dargestellt) erzeugt, die fünfte Bereiche B5, in denen der erste Transistor, der zweite Transistor, der dritte Transistor und der vierte Transistor erzeugt werden, nicht bedeckt (s. Fig. 10). Anschließend wird mit z.B. CF₄/CHF₃/He Siliziumnitrid selektiv zu SiO₂ und Silizium geätzt, wodurch eine erste isolierende Struktur I1 gebildet wird, die in den fünften Bereichen B5 spacerförmig und außerhalb der fünften Bereichen B5 konform ist (siehe Fig. 4 und Fig. 5). Anschließend wird durch thermische Oxidation mit geringem Temperaturbudget bei einer Temperatur von ca. 600°C und einem Druck von ca. 10⁶Pa eine zweite isolierende Struktur I2 gebildet (siehe Figur 5). Anschließend wird Siliziumnitrid mit z.B. H₃PO naß geätzt, und die dritte Maske durch nasses Ätzen mit z.B. HF entfernt. Durch thermische Oxidation wird ein Gatedielektrikum Gd aufgewachsen. Das Gatedielektrikum Gd entsteht an Stellen, an denen sich Teile der ersten isolierenden Struktur I1 innerhalb der fünften Bereiche B5 befanden.

Anschließend wird in Situ dotiertes Polysilizium abgeschieden. Mit Hilfe einer vierten Fotolackmaske MF4, die den dritten Bereich B3 und den vierten Bereich B4 im wesentlichen bedeckt (s. Fig. 10), wird Polysilizium mit z.B. Cl₂/CHF₃ geätzt, wodurch an gegenüberliegenden Flanken der ersten Schichtstruktur St1 eine spacerförmige erste Gateelektrode Ga1, an gegenüberliegenden Flanken der zweiten Schichtstruktur St2 eine spacerförmige zweite Gateelektrode Ga2, an gegenüberliegenden Flanken der dritten Schichtstruktur St3 eine spacerförmige dritte Gateelektrode Ga3 und an gegenüberliegenden Flanken der vierten Schichtstruktur St4 eine spacerförmige vierte Gateelektrode Ga4 entstehen. Polysilizium unter der vierten Fotolackmaske MF4 dient als erste Kontaktfläche, die die dritte Gateelektrode Ga3 mit der vierten Gateelektrode Ga4 verbindet, und als zweite Kontaktfläche, die die erste Gateelektrode Ga1 mit der zweiten Gateelektrode Ga2 verbindet. Auf der ersten Kontaktfläche werden später ein erster Kontakt K1 und auf der zweiten Kontaktfläche ein zweiter Kontakt K2 erzeugt.

Die zweite isolierende Struktur I2 vermindert Kapazitäten, die durch die erste Gateelektrode Ga1 und der zweiten Schicht S2, durch die zweite Gateelektrode Ga2 und der ersten Schicht S1, durch die dritte Gateelektrode Ga3 und der ersten Schicht S1, und durch die vierte Gateelektrode Ga4 und der zweiten Schicht S2 gebildet werden.

Die Abmessungen des ersten Bereichs B1 und des zweiten Bereichs B2 wurden so gewählt, daß Polysilizium nach dem Ätzen diese Bereiche im wesentlichen bedeckt (siehe Figur 6).

Anschließend wird SiO₂ in einer Dicke von ca. 300 nm abgeschieden und mit z.B. Cl₂/CHF₃ rückgeätzt, wodurch eine dritte isolierende Struktur I3 erzeugt wird, die die erste Gateelektrode Ga1, die zweite Gateelektrode Ga2, die dritte Gateelektrode Ga3 und die vierte Gateelektrode Ga4, bedeckt. Anschließend wird Siliziumnitrid in einer Dicke von ca. 200 nm abgeschieden. Mit Hilfe einer fünften Fotolackmaske (nicht dargestellt) werden für Kontakte Vertiefungen erzeugt. Dabei wird mit z.B. CF₄/CHF₃/H₂ Siliziumnitrid selektiv zu SiO₂ geätzt. Die dritte isolierende Struktur I3 aus SiO₂ dient als Ätzstop. Für den ersten Kontakt K1 wird eine Vertiefung bis zur ersten Kontaktfläche erzeugt. Für den zweiten Kontakt K2 wird eine Vertiefung bis zur zweiten Kontaktfläche erzeugt. Für einen dritten der Kontakte K3 wird eine Vertiefung erzeugt, die die Stufe Stu überlappt. Für einen vierten der Kontakte K4 wird in einer von der zweiten Maske M2 ursprünglich abgedeckten Stelle eine Vertiefung bis zu einem Teil der zweiten Schicht S2, der als elektrische Verbindung zum ersten Source/Drain-Gebiet des ersten Transistors dient, erzeugt. Für einen fünften der Kontakte K5 wird eine Vertiefung bis zum ersten Source/Drain-Gebiets des dritten Transistors erzeugt. Für einen sechsten der Kontakte K6 wird eine Vertiefung bis zum ersten Source/Drain-Gebiets des zweiten Transistors erzeugt. Für einen siebten der Kontakte K7 wird eine Vertiefung bis zum ersten Source/Drain-Gebiets des vierten Transistors erzeugt. Für einen achten der Kontakte K8 wird eine Vertiefung bis zum zweiten Source/Drain-Gebiets des ersten Transistors erzeugt.

In einer Dicke von ca. 100nm wird Titan abgeschieden und selektiv siliziert, wodurch Kontaktstrukturen Ks entstehen. Übrigbleibendes Titan wird mit z.B. CCl₂F₂/NF₃ entfernt.

In einer Dicke von ca. 400 nm wird Aluminium abgeschieden, wodurch die Kontakte K1, K2, K3, K4, K5, K6, K7, K8 entstehen. Anschließend wird das Aluminium so strukturiert, daß eine erste leitende Struktur L1 erzeugt wird, die den siebten Kontakt K7 und den achten Kontakt K8 miteinander verbindet und eine zweite leitende Struktur L2 erzeugt wird, die den fünften Kontakt K5 und den sechsten Kontakt K6 miteinander verbindet (siehe Figur 6). Die Kontaktstrukturen Ks verringern die elektrischen Widerstände der Kontakte K1, K2, K3, K4, K5, K6, K7, K8.

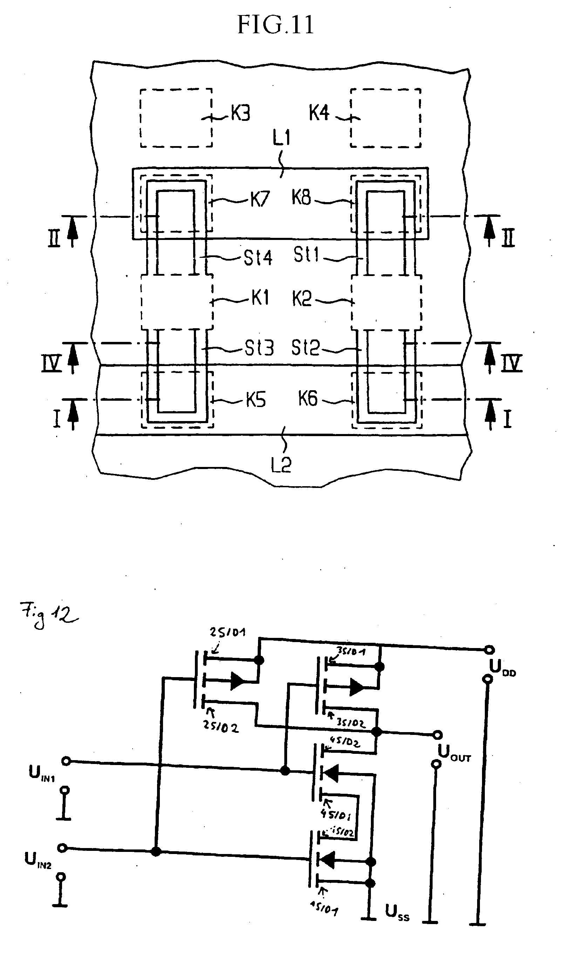

Die vier Transistoren bilden ein NAND-Gatter (siehe Figur 12). Der erste Kontakt K1 wird mit einem ersten Eingangsspannungsanschluß U_{IN1} verbunden. Der zweite Kontakt K2 wird mit einem zweiten Eingangsspannungsanschluß U_{IN2} verbunden. Der dritte Kontakt K3 wird mit einem Ausgangsspannungsanschluß U_{OUT} verbunden. Der vierte Kontakt K4 wird mit einem ersten Spannungsanschluß U_{SS} verbunden. Die zweite leitende Struktur L2 wird mit einem zweiten Spannungsanschluß U_{DD} verbunden.

Es sind viele Variationen des Ausführungsbeispiels denkbar, die ebenfalls im Rahmen der Erfindung liegen. Insbesondere können die Abmessungen der beschriebenen Schichten, Gebiete, Bereiche und Strukturen an die jeweiligen Erfordernisse angepaßt werden. Dasselbe gilt auch für die vorgeschlagenen Dotierstoffkonzentrationen. Die zweite isolierende Struktur kann auch durch ein Abscheidungsverfahren erzeugt werden. Isolierende Strukturen können auch aus anderen isolierenden Materialien erzeugt werden. Statt dotiertem Polysilizium lassen sich auch z.B. Metallsilizide und/oder Metalle verwenden.

## Patentansprüche

1. Schaltungsanordnung mit mindestens vier Transistoren,
- bei der die Transistoren vertikale MOS-Transistoren sind,
- bei der ein erster der Transistoren und ein vierter der Transistoren komplementär zu einem zweiten der Transistoren und einem dritten der Transistoren sind,
- bei der der erste Transistor und der vierte Transistor in Reihe und zwischen einem ersten Spannungsanschluß (U_{SS}) und einem Ausgangsspannungsanschluß (U_{OUT}) geschaltet sind,
- bei der der zweite Transistor und der dritte Transistor parallel verschaltet und zwischen dem Ausgangsspannungsanschluß (U_{OUT}) und einem zweiten Spannungsanschluß (U_{DD}) geschaltet sind,
- bei der eine Gateelektrode (Ga3) des dritten Transistors und eine Gateelektrode (Ga4) des vierten Transistors mit einem ersten Eingangsspannungsanschluß (U_{IN1}) verbunden sind,
- bei der eine Gateelektrode (Ga1) des ersten Transistors und eine Gateelektrode (Ga2) des zweiten Transistors mit einem zweiten Eingangsspannungsanschluß (U_{IN2}) verbunden sind,
- bei der Schichtstrukturen (St1, St2, St3, St4) vorgesehen sind, die Kanalschichten (Ka1, Ka2, Ka3, Ka4) der Transistoren und mindestens ein Source/Drain-Gebiet (3S/D1, 2S/D1, 4S/D1, 1S/D2) jedes Transistors umfassen,
- bei der die Schichtstrukturen (St1, St2, St3, St4) Flanken aufweisen, an die die Kanalschichten (Ka1, Ka2,Ka3,Ka4) angrenzen und die mindestens im Bereich der Kanalschichten (Ka1, Ka2, Ka3, Ka4) mit einem Gatedielektrikum (Gd) versehen sind, an das die Gateelektroden (Ga1, Ga2, Ga3, Ga4) der Transistoren angrenzen,
- bei der sich die Kanalschicht (Ka1) des ersten Transistors und die Kanalschicht (Ka4) des vierten Transistors in gleicher Höhe befinden,
- bei der sich die Kanalschicht (Ka2) des zweiten Transistors und die Kanalschicht (Ka3) des dritten Transistors in gleicher Höhe befinden,
- bei der sich die Kanalschicht (Ka1) des ersten Transistors und die Kanalschicht (Ka2) des zweiten Transistors in unterschiedlicher Höhe befinden,
- bei der ein erstes der Source/Drain-Gebiete (2S/D1) des zweiten Transistors oberhalb der Kanalschicht (Ka2) des zweiten Transistors angeordnet ist,
- bei der ein erstes der Source/Drain-Gebiete (3S/D1) des dritten Transistors oberhalb der Kanalschicht (Ka3) des dritten Transistors angeordnet ist,
- bei der ein erstes der Source/Drain-Gebiete (4S/D1) des vierten Transistors oberhalb der Kanalschicht (Ka4) des vierten Transistors angeordnet ist,
- bei der ein zweites der Source/Drain-Gebiete (1S/D2) des ersten Transistors oberhalb der Kanalschicht (Ka1) des ersten Transistors angeordnet ist,
- bei der das zweite Source/Drain-Gebiet (1S/D2) des ersten Transistors über eine erste leitende Struktur (L1) mit dem ersten Source/Drain-Gebiet (4S/D1) des vierten Transistors verbunden ist,
- bei der das erste Source/Drain-Gebiet (2S/D1) des zweiten Transistors über eine zweite leitende Struktur (L2) mit dem ersten Source/Drain-Gebiet (3S/D1) des dritten Transistors und mit dem zweiten Spannungsanschluß verbunden ist,
- bei der ein zweites der Source/Drain-Gebiete (2S/D2) des zweiten Transistors und ein zweites der Source/Drain-Gebiete (3S/D2) des dritten Transistors ineinander übergehen,
- bei der das zweite Source/Drain-Gebiet (3S/D2) des dritten Transistors und ein zweites der Source/Drain-Gebiete (4S/D2) des vierten Transistors über dem dritten Transistor und dem vierten Transistor hinaus verlängert sind und eine Stufe (Stu) bilden,
- bei der ein Kontakt (K3) des Ausgangsspannungsanschlusses (U_{OUT}) an der Stufe (Stu) angeordnet ist.

2. Schaltungsanordnung nach Anspruch 1,
- bei der eine Verbindungslinie, die den ersten Transistor mit dem zweiten Transistor, den zweiten Transistor mit dem dritten Transistor, den dritten Transistor mit dem vierten Transistor und den vierten Transistor mit dem ersten Transistor verbindet im wesentlichen viereckig oder eine gerade Linie ist.

3. Schaltungsanordnung nach einem der Ansprüche 1 oder 2,
- bei der ein Kontakt (K1) des ersten Eingangsspannungsanschlusses (U_{IN1}) zwischen dem dritten und dem vierten Transistor angeordnet ist,
- bei der ein Kontakt (K2) des zweiten Eingangsspannungsanschlusses (U_{IN2}) zwischen dem ersten Transistor und dem zweiten Transistor angeordnet ist.

4. Verfahren zur Herstellung einer Schaltungsanordnung mit mindestens vier Transistoren,
- bei dem zuerst eine Schichtenfolge erzeugt wird, die mindestens eine von einem ersten Leitfähigkeitstyp dotierte erste Schicht (S1), eine darüber angeordnete von einem zweiten, zum ersten Leitfähigkeitstyp entgegengesetzten Leitfähigkeitstyp dotierte zweite Schicht (S2), eine darüber angeordnete vom ersten Leitfähigkeitstyp dotierte dritte Schicht (S3) und eine darüber angeordnete vom zweiten Leitfähigkeitstyp dotierte vierte Schicht (S4) umfaßt,
- bei dem aus der Schichtenfolge Schichtstrukturen (St1, St2, St3, St4) durch einen Ätzprozeß gebildet werden, bei dem Spacer (Sp1, Sp2) als eine erste Maske dienen, wobei:
a) zur Erzeugung der Spacer (Sp1, Sp2) eine erste Hilfsschicht (H1) erzeugt wird, die so strukturiert wird, daß sich Kanten (Kn1, Kn2) bilden,
b) nach der Erzeugung der strukturierten ersten Hilfsschicht (H1) eine zweite Hilfsschicht erzeugt und rückgeätzt wird, so daß angrenzend an die Kanten (Kn1, Kn2) der ersten Hilfsschicht (H1) aus der zweiten Hilfsschicht die Spacer (Sp1, Sp2) entstehen,
c) nachfolgend zur Erzeugung zweier Schichtstrukturen (St1, St4) die Schichtenfolge strukturiert wird, wobei mindestens bis in die dritte Schicht (S3) geätzt wird,
d) zur Erzeugung zweiter weiterer Schichtstrukturen (St2, St3) die Schichtenfolge strukturiert wird, wobei mindestens bis in die zweite Schicht (S2) geätzt wird,
- bei dem Flanken der zwei Schichtstrukturen (St1, St4) mindestens im Bereich der dritten Schicht (S3) mit einem Gatedielektrikum (Gd) versehen werden und daran angrenzend Gateelektroden (Ga1, Ga4) erzeugt werden,
- bei dem Flanken der zwei weiteren Schichtstrukturen (St2, St3) mindestens im Bereich der zweiten Schicht (S2) mit dem Gatedielektrikum (Gd) versehen werden und daran angrenzend Gateelektroden (Ga2, Ga3) erzeugt werden,
- bei dem Teile der Schichten (S1, S2, S3, S4) und die Gateelektroden (Ga1, Ga2, Ga3, Ga4) so verbunden werden, daß eine Schaltungsanordnung erzeugt wird, bei die Schichtstrukturen (St1, St2, St3, St4) Teile von vertikalen Transistoren sind, und ein erster der Transistoren und ein vierter der Transistoren in Reihe und zwischen einem ersten Spannungsanschluß (U_{SS}) und einem Ausgangsspannungsanschluß (U-_{OUT}) geschaltet sind, und ein zweiter der Transistoren und ein dritter der Transistoren parallel verschaltet und zwischen dem Ausgangsspannungsanschluß (U_{OUT}) und einem zweiten Spannungsanschluß (U_{DD}) geschaltet sind, und zwei der Gateelektroden (Ga3, Ga4), von denen eine dem dritten Transistor und eine dem vierten Transistor zugeordnet sind, mit einem ersten Eingangsspannungsanschluß (U_{IN1}) verbunden sind, und zwei weitere der Gateelektroden (Ga1, Ga2), von denen eine dem ersten Transistor und eine dem zweiten Transistor zugeordnet sind, mit einem zweiten Eingangsspannungsanschluß (U_{IN2}) verbunden sind.

5. Verfahren nach Anspruch 4,
- bei dem ein erster Spacer (Sp1) der Spacer (Sp1, Sp2) entlang Ränder eines ersten rechteckigen Bereichs (B1) erzeugt wird,
- bei dem ein zweiter Spacer (Sp2) der Spacer (Sp1, Sp2) entlang Ränder eines rechteckigen zweiten Bereichs (B2) erzeugt wird,
- bei dem anschließend in einem dritten Bereich (B3), der den ersten Bereich (B1) quer überlappt, ein Teil des ersten Spacers (Sp1) entfernt wird,
- bei dem in einem vierten Bereich (B4), der den zweiten Bereich (B2) quer überlappt, ein Teil des zweiten Spacers (Sp2) entfernt wird,
- bei dem anschließend die strukturierte Hilfsschicht (H1) entfernt wird,
- bei dem anschließend durch Ätzen Teile von mindestens zwei Schichten (S3, S4) der Schichtenfolge entfernt werden, wobei der erste Spacer (Sp1) und der zweite Spacer (Sp2) als die erste Maske wirken,
- bei dem anschließend der erste Spacer (Sp1) und der zweite Spacer (Sp2) entfernt werden,
- bei dem anschließend mit Hilfe einer zweiten Maske (M2), die eine erste Hälfte des ersten Bereichs (B1) überlappt sowie eine erste Hälfte des zweiten Bereichs (B2) bedeckt, ein Teil einer Schicht (S2) der Schichtenfolge entfernt wird, wodurch die erste Schicht und die zweite Schicht außerhalb des ersten Bereichs und des zweiten Bereichs eine Stufe (Stu) bilden,
- bei dem eine erste isolierende Schicht (I1) erzeugt wird, die mindestens einen Bereich bedeckt, in dem sich der erste Bereich (B1) mit dem dritten Bereich (B3) überschneidet, und ein Bereich, in dem sich der zweite Bereich (B2) und der vierte Bereich (B4) überschneiden,
- bei dem Material abgeschieden wird und mit Hilfe einer vierten Maske (MF4), die mindestens den Bereich, in dem sich der erste Bereich (B1) mit dem dritten Bereich (B3) überschneidet und den Bereich, in dem sich der zweite Bereich (B2) mit dem vierten Bereich (B4) überschneidet, bedeckt, geätzt wird, wodurch die Gateelektroden (Ga1, Ga2, Ga3, Ga4) und zwei Kontaktflächen erzeugt werden,
- bei dem ein Kontakt (K3) des Ausgangsspannungsanschlusses (U_{OUT}) so gebildet wird, daß er die Stufe (Stu) überlappt.

## Claims

1. Circuit arrangement with at least four transistors,
- in which the transistors are vertical MOS transistors,
- in which a first one of the transistors and a fourth one of the transistors are complementary to a second one of the transistors and a third one of the transistors,
- in which the first transistor and the fourth transistor are connected in series and between a first voltage terminal (U_{SS}) and an output voltage terminal (U_{OUT}),
- in which the second transistor and the third transistor are connected up in parallel and are connected between the output voltage terminal (U_{OUT}) and a second voltage terminal (U_{DD}),
- in which a gate electrode (Ga3) of the third transistor and a gate electrode (Ga4) of the fourth transistor are connected to a first input voltage terminal (U_{IN1}),
- in which a gate electrode (Ga1) of the first transistor and a gate electrode (Ga2) of the second transistor are connected to a second input voltage terminal (U_{IN2}),
- in which layer structures (St1, St2, St3, St4) are provided which comprise channel layers (Ka1, Ka2, Ka3, Ka4) of the transistors and at least one source/drain region (3S/D1, 2S/D1, 4S/D1, 1S/D2), of each transistor,
- in which the layer structures (St1, St2, St3, St4) have sidewalls which are adjoined by the channel layers (Ka1, Ka2, Ka3, Ka4) and which, at least in the region of the channel layers (Ka1, Ka2, Ka3, Ka4), are provided with a gate dielectric (Gd) adjoined by the gate electrodes (Ga1, Ga2, Ga3, Ga4) of the transistors,
- in which the channel layer (Ka1) of the first transistor and the channel layer (Ka4) of the fourth transistor are situated at the same level,
- in which the channel layer (Ka2) of the second transistor and the channel layer (Ka3) of the third transistor are situated at the same level,
- in which the channel layer (Ka1) of the first transistor and the channel layer (Ka2) of the second transistor are situated at different levels,
- in which a first one of the source/drain regions (2S/D1) of the second transistor is arranged above the channel layer (Ka2) of the second transistor,
- in which a first one of the source/drain regions (3S/D1) of the third transistor is arranged above the channel layer (Ka3) of the third transistor,
- in which a first one of the source/drain regions (4S/D1) of the fourth transistor is arranged above the channel layer (Ka4) of the fourth transistor,
- in which a second one of the source/drain regions (1S/D2) of the first transistor is arranged above the channel layer (Ka1) of the first transistor,
- in which the second source/drain region (1S/D2) of the first transistor is connected to the first source/drain region (4S/D1) of the fourth transistor via a first conductive structure (L1),
- in which the first source/drain region (2S/D1) of the second transistor is connected via a second conductive structure (L2) to the first source/drain region (3S/D1) of the third transistor and to the second voltage terminal,
- in which a second one of the source/drain regions (2S/D2) of the second transistor and a second one of the source/drain regions (3S/D2) of the third transistor merge into one another,
- in which the second source/drain region (3S/D2) of the third transistor and a second one of the source/drain regions (4S/D2) of the fourth transistor are lengthened beyond the third transistor and the fourth transistor and form a step (Stu) and
- in which a contact (K3) of the output voltage terminal (U_{OUT}) is arranged at the step (Stu).

2. Circuit arrangement according to Claim 1,
- in which a connecting line which connects the first transistor to the second transistor, the second transistor to the third transistor, the third transistor to the fourth transistor and the fourth transistor to the first transistor is substantially quadrangular or a straight line.

3. Circuit arrangement according to either of Claims 1 and 2,
- in which a contact (K1) of the first input voltage terminal (U_{IN1}) is arranged between the third and the fourth transistor,
- in which a contact (K2) of the second input voltage terminal (U_{IN2}) is arranged between the first transistor and the second transistor.

4. Method for fabricating a circuit arrangement with at least four transistors,
- in which firstly a layer sequence is produced which comprises at least one first layer (S1) doped by a first conductivity type, a second layer (S2) arranged thereabove and doped by a second conductivity type, which is opposite to the first conductivity type, a third layer (S3) arranged thereabove and doped by the first conductivity type, and a fourth layer (S4) arranged thereabove and doped by the second conductivity type,
- in which layer structures (St1, St2, St3, St4) are formed from the layer sequence by means of an etching process, in which spacers (Sp1, Sp2) serve as a first mask, wherein:
a) a first auxiliary layer (H1) is produced for producing the spacers (Sp1, Sp2), said first auxiliary layer being patterned in such a way that edges (Kn1, Kn2) form,
b) after producing the patterned first auxiliary layer (H1) a second auxiliary layer is produced and etched back, such that the spacers (Sp1, Sp2) arise from the second auxiliary layer in a manner adjoining the edges (Kn1, Kn2) of the first auxiliary layer (H1),
c) the layer sequence is subsequently patterned for producing two layer structures (St1, St4), wherein etching is effected at least right into the third layer (S3),
d) the layer sequence is patterned for producing second further layer structures (St2, St3), wherein etching is effected at least right into the second layer (S2),
- in which sidewalls of the two layer structures (St1, St4) at least in the region of the third layer (S3) are provided with a gate dielectric (Gd) and gate electrodes (Ga1, Ga4) are produced in a manner adjoining the latter,
- in which sidewalls of the two further layer structures (St2, St3) at least in the region of the second layer (S2) are provided with the gate dielectric (Gd) and gate electrodes (Ga2, Ga3) are produced in a manner adjoining the latter,
- in which parts of the layers (S1, S2, S3, S4) and the gate electrodes (Ga1, Ga2, Ga3, Ga4) are connected in such a way that a circuit arrangement is produced in which the layer structures (St1, St2, St3, St4) are parts of vertical transistors, and a first one of the transistors and a fourth one of the transistors are connected in series and between a first voltage terminal (U_{SS}) and an output voltage terminal (U_{OUT}), and a second one of the transistors and a third one of the transistors are connected up in parallel and are connected between the output voltage terminal (U_{OUT}) and a second voltage terminal (U_{DD}), and two of the gate electrodes (Ga3, Ga4) of which one is assigned to the third transistor and one is assigned to the fourth transistor, are connected to a first input voltage terminal (U_{IN1}), and two further gate electrodes (Ga1, Ga2), of which one is assigned to the first transistor and one is assigned to the second transistor, are connected to a second input voltage terminal (U_{IN2}).

5. Method according to Claim 4,
- in which a first spacer (Sp1) from the spacers (Sp1, Sp2) is produced along edges of a first rectangular region (B1),
- in which a second spacer (Sp2) from the spacers (Sp1, Sp2) is produced along edges of a second rectangular region (B2),
- in which a part of the first spacer (Sp1) is subsequently removed in a third region (B3), which transversely overlaps the first region (B1),
- in which a part of the second spacer (Sp2) is removed in a fourth region (B4), which transversely overlaps the second region (B2),
- in which the patterned auxiliary layer (H1) is subsequently removed,
- in which parts of at least two layers (S3, S4) of the layer sequence are subsequently removed by etching, wherein the first spacer (Sp1) and the second spacer (Sp2) act as the first mask,
- in which the first spacer (Sp1) and the second spacer (Sp2) are subsequently removed,
- in which a part of a layer (S2) of the layer sequence is subsequently removed with the aid of a second mask (M2), which overlaps a first half of the first region (B1) and also covers a first half of the second region (B2), whereby the first layer and the second layer form a step (Stu) outside the first region and the second region,
- in which a first insulating layer (I1) is produced, which covers at least one region in which the first region (B1) overlaps the third region (B3) and a region in which the second region (B2) and the fourth region (B4) overlap,
- in which material is deposited and is etched with the aid of a fourth mask (MF4) which covers at least the region in which the first region (B1) overlaps the third region (B3) and the region in which the second region (B2) overlaps the fourth region (B4), whereby the gate electrodes (Ga1, Ga2, Ga3, Ga4) and two contact areas are produced,
- in which a contact (K3) of the output voltage terminal (U_{OUT}) is formed in such a way that it overlaps the step (Stu).

## Revendications

1. Montage ayant au moins quatre transistors,
- dans lequel les transistors sont des transistors MOS verticaux,
- dans lequel un premier des transistors et un quatrième des transistors sont complémentaires d'un deuxième des transistors et d'un troisième des transistors,
- dans lequel le premier transistor et le quatrième transistor sont montés en série et entre une borne (U_{SS}) de tension et une borne (U_{OUT}) de tension de sortie,
- dans lequel le deuxième transistor et le troisième transistor sont montés en parallèle et sont montés entre la borne (U_{OUT}) de tension de sortie et une deuxième borne (U_{DD}) de tension,
- dans lequel une électrode (Ga3) de grille du troisième transistor et une électrode (Ga4) de grille du quatrième transistor sont reliées à une première borne (U_{IN1}) de tension d'entrée,
- dans lequel une électrode (Ga1) de grille du premier transistor et une électrode (Ga2) de grille du deuxième transistor sont reliées à une deuxième borne (U_{IN2}) de tension d'entrée,
- dans lequel il est prévu des structures (St1, St2, St3, St4) stratifiées qui comprennent les couches (Ka1, Ka2, Ka3, Ka4) de canal des transistors et au moins une zone (3S/D1, 2S/D1, 4S/D1, 1S/D2) de source/drain de chaque transistor,
- dans lequel les structures (St1, St2, St3, St4) stratifiées ont des flancs dont les couches (Ka1, Ka2, Ka3, Ka4) de canal sont voisines et qui sont munis, au moins dans la partie des couches (Ka1, Ka2, Ka3, Ka4) de canal, d'un diélectrique (Gd) de grille dont les électrodes (Ga1, Ga2, Ga3, Ga4) de grille des transistors sont voisines,
- dans lequel la couche (Ka1) de canal du premier transistor et la couche (Ka4) de canal du quatrième transistor se trouvent au même niveau,
- dans lequel la couche (Ka2) de canal du deuxième transistor et la couche (Ka3) de canal du troisième transistor se trouvent au même niveau,
- dans lequel la couche (Ka1) de canal du premier transistor et la couche (Ka2) de canal du deuxième transistor se trouvent à des niveaux différents,
- dans lequel une première des zones (2S/D1) de source/drain du deuxième transistor est disposée au-dessus de la couche (Ka2) de canal du deuxième transistor,
- dans lequel une première des zones (3S/D1) de source/drain du troisième transistor est disposée au-dessus de la couche (Ka3) de canal du troisième transistor,
- dans lequel une première des zones (4S/D1) de source/drain du quatrième transistor est disposée au-dessus de la couche (Ka4) de canal du quatrième transistor,
- dans lequel une deuxième des zones (1S/D2) de source/drain du premier transistor est disposée au-dessus de la couche (Ka1) de canal du premier transistor,
- dans lequel la deuxième zone (1S/D2) de source/drain du premier transistor est reliée par une première structure (L1) conductrice à la première zone (4S/D1) de source/drain du quatrième transistor,
- dans lequel la première zone (2S/D1) de source/drain du deuxième transistor est reliée par une deuxième structure (L2) conductrice à la première zone (3S/D1) de source/drain du troisième transistor et à la deuxième borne de tension,
- dans lequel une deuxième des zones (2S/D2) de source/drain du deuxième transistor et une deuxième des zones (3S/D2) de source/drain du troisième transistor se confondent l'une avec l'autre,
- dans lequel la deuxième zone (3S/D2) de source/drain du troisième transistor et une deuxième des zones (4S/D2) de source/drain du quatrième transistor se prolongent au-delà du troisième transistor et du quatrième transistor et forment un palier (Stu), et
- dans lequel un contact (K3) de la borne (U_{OUT}) de tension de sortie est disposé sur le palier (Stu).

2. Montage suivant la revendication 1,
- dans lequel une ligne de liaison, qui relie le premier transistor au deuxième transistor, le deuxième transistor au troisième transistor, le troisième transistor au quatrième transistor et le quatrième transistor au premier transistor, est une ligne sensiblement quadrangulaire ou une ligne droite.

3. Montage suivant l'une des revendications 1 ou 2,
- dans lequel un contact (K1) de la première borne (U_{IN1}) de tension d'entrée est disposé entre le troisième et le quatrième transistor,
- dans lequel un contact (K2) de la deuxième borne (U_{IN2}) de tension d'entrée est disposé entre le premier transistor et le deuxième transistor.

4. Procédé de production d'un montage ayant au moins quatre transistors,
- dans lequel on produit d'abord une succession stratifiées, qui comprend au moins une première couche (S1) dopée par un premier type de conductivité, une deuxième couche (S2) disposée au-dessus et dopée par un deuxième type de conductivité opposée au premier type de conductivité, une troisième couche (S3) disposée au-dessus et dopée par le premier type de conductivité et une quatrième couche (S4) disposée au-dessus et dopée par le deuxième type de conductivité,
- dans lequel on forme, à partir de la succession de couches, des structures (St1, St2, St3, St4) stratifiées par une opération d'attaque, dans laquelle des espaceurs (Sp1, Sp2) servent de premier masque, dans lequel :
a) pour produire les espaceurs (Sp1, Sp2), on produit une première couche (H1) auxiliaire structurée de façon à former des bords (Kn1, Kn2),
b) après introduction de la première couche (H1) auxiliaire structurée, on produit une deuxième couche auxiliaire et on l'attaque en retrait, de manière à créer les espaceurs (Sp1, Sp2) à partir de la deuxième couche auxiliaire au voisinage des bords (Kn1, Kn2) de la première couche (H1) auxiliaire,
c) après l'introduction de deux structures (St1, St4) stratifiées, on structure la succession de couches en l'attaquant au moins jusqu'à la troisième couche (S3),
d) pour la production de deuxièmes structures (St2, St3) stratifiées supplémentaires, on structure la succession de couches en attaquant au moins jusqu'à la deuxième couche (S2),
- dans lequel on munit les flancs des deux structures (St1, St4) stratifiées au moins dans la partie de la troisième couche (S3) d'un diélectrique (Gd) de grille et on y produit au voisinage des électrodes (Ga1, Ga4) de grille,
- dans lequel on munit des flancs des deux structures (St2, St3) stratifiées supplémentaires, au moins dans la partie de la deuxième couche (S2), du diélectrique (Gd) de grille et on y produit au voisinage des électrodes (Ga2, Ga3) de grille,
- dans lequel on relie des parties des couches (S1, S2, S3, S4) et les électrodes (Ga1, Ga2, Ga3, Ga4) de grille, de façon à produire un montage dans lequel les structures (St1, St2, St3, St4) stratifiées font partie de transistors verticaux et on monte un premier des transistors et un quatrième des transistors en série et entre une première borne (U_{SS}) de tension et une borne (U_{OUT}) de tension de sortie et un deuxième des transistors et un troisième des transistors en parallèle et entre la borne (U_{OUT}) de tension de sortie et une deuxième borne (U_{DD}) de tension et deux des électrodes (Ga3, Ga4) de grille dont l'une est associée au troisième transistor et une autre au quatrième transistor sont reliées à une première borne (U_{IN1}) de tension d'entrée et deux autres des électrodes (Ga1, Ga2) de grille, dont l'une est associée au premier transistor et l'autre au deuxième transistor, sont reliées à une deuxième borne (U_{IN2}) de tension d'entrée.

5. Procédé suivant la revendication 4,
- dans lequel on produit un premier espaceur (Sp1) des espaceurs (Sp1, Sp2) le long des bords d'une première partie (B1) quadrangulaire,
- dans lequel on produit un deuxième espaceur (Sp2) des espaceurs (Sp1, Sp2) le long des bords d'une deuxième partie (B2) quadrangulaire,
- dans lequel, ensuite, on élimine dans une troisième partie (B3), qui est à recouvrement transversalement avec la première partie (B1), une partie du premier espaceur (Sp1),
- dans lequel on élimine dans une deuxième partie (B4), qui est à recouvrement transversalement avec la deuxième partie (B2), une partie du deuxième espaceur (Sp2),
- dans lequel on élimine ensuite la couche (H1) auxiliaire structurée,
- dans lequel on élimine ensuite par attaque les parties d'au moins deux couches (S3, S4) de la succession de couches, le premier espaceur (Sp1) et le deuxième espaceur (Sp2) servant de premier masque,
- dans lequel on élimine ensuite le premier espaceur (Sp1) et le deuxième espaceur (Sp2),
- dans lequel on élimine ensuite à l'aide d'un deuxième masque (M2), qui recouvre la première moitié de la première partie (B1) ainsi qu'une première moitié de la deuxième partie (B2), une partie de couche (S2) de la succession de couches, de sorte que la première couche et la deuxième couche forment un palier (Stu) à l'extérieur de la première partie et de la deuxième partie,
- dans lequel on produit une première couche (I1) isolante qui recouvre au moins une partie dans laquelle la première partie (B1) se recoupe avec la troisième partie (B3) et une partie dans laquelle la deuxième partie (B2) et la quatrième partie (B4) se recouvrent,
- dans lequel on dépose du matériau et on attaque à l'aide d'un quatrième masque (MF4), qui recouvre au moins la partie dans laquelle la première partie (B1) se recoupe avec la troisième partie (B3) et la partie dans laquelle la deuxième partie (B2) se recoupe avec la quatrième partie (B4), de façon à produire les électrodes (Ga1, Ga2, Ga3, Ga4) de grille et deux surfaces de contact,
- dans lequel on forme un contact (K3) de la borne (U_{OUT}) de tension de sortie, de façon à ce qu'il recouvre le palier (Stu).
